Europäisches Patentamt

European Patent Office

Office européen des brevets

(19)

(11) Publication number: **0 586 702 A1**

## EUROPEAN PATENT APPLICATION
## published in accordance with Art. 158(3) EPC

(12)

(21) Application number: 92911763.8

(22) Date of filing: **28.04.92**

(51) Int. Cl.⁵: **C23C 14/32**

(86) International application number:
**PCT/RU92/00095**

(87) International publication number:
**WO 92/19789 (12.11.92 92/28)**

(30) Priority: **29.04.91 SU 4931910**
**29.04.91 SU 4948577**
**11.09.91 SU 5002414**

(43) Date of publication of application:
**16.03.94 Bulletin 94/11**

(84) Designated Contracting States:
**DE NL**

(71) Applicant: **NAUCHNO-PROIZVODSTVENNOE PREDPRIVATIE "NOVATEKH"**
**Tikhvinsky per., 11-a/aya 116**
**Moscow, 103055(RU)**

(72) Inventor: **SABLEV, Leonid Pavlovich**
**ul. P.Morozova, 3-3**
**Kharkov, 310108(UA)**
Inventor: **ANDREEV, Anatoly Afanasievich**
**ul. Danilevskogo, 31-47**
**Kharkov, 310058(UA)**
Inventor: **GRIGORIEV, Sergei Nikolaevich**
**Vadkovsky per., 18a-209**
**Moscow, 103055(RU)**

(74) Representative: **Lehn, Werner, Dipl.-Ing. et al**
**Hoffmann, Eitle & Partner,**
**Patentanwälte,**
**Arabellastrasse 4**
**D-81925 München (DE)**

(54) **ELECTRIC ARC EVAPORATOR OF METALS.**

(57) An electric arc evaporator of metals comprises a cathode (2) extended along its longitudinal axis, made of the material to be evaporated and having the evaporation surface (3) oriented along its longitudinal axis, and current leads (7, 8) located on the opposite end faces (5, 6) of the cathode (2) and connected to controlled switches (10, 11) electrically connected through individual switching elements (12, 13) to a control unit (14) and connected to a constant-current source (15) connected, in its turn, to the anode, and electrically connected to the control unit (14) transducer (17) of the current location of the cathode spot (16) on the evaporation surface (3) of the cathode (2). In a particular case the cathode (2) itself serves as the transducer (17), and its current leads (7, 8) serve as current leads of the transducer (17).

FIG.1

Field of the Invention

The field of this invention is devices for product processing, electric arc metal evaporators, to be more precise.

Prior Art

It is known electric arc metal evaporator having cathode, which is made of evaporating metal and which has evaporation surface, and direct current power supply connected to cathode and anode (US, A, 3793179).

In the above mentioned evaporator, surface of product is processed by cathode spot of electric vacuum arc which moves chaotically over cathode surface. Active evaporation of cathode material from its surface and deposition of evaporated metal on products, which are placed opposite to cathode evaporation surface, is happened due to high concentration of energy in cathode spot of electric arc.

When long objects are processed it is necessary to use several evaporators placed along long objects. This results in difficulties when this evaporator is used.

It is known electric arc metal evaporator having anode, which is extended along its longitudinal axis and which evaporation surface is placed along its longitudinal axis, and connecting leads, which are placed on the opposite sides of cathode and are connected to controlled switches, which are connected to each other through separate turn-on members. These members have control unit and are connected to direct current power supply, which is also connected to anode. Device also has unit for determination of cathode spot position on cathode evaporation surface. This unit is connected to control unit (SU, A, 461163).

Unit for determination of cathode spot position on cathode evaporation surface is constructed using detectors of final position of cathode spot.
Cathode spot under magnetic field of current passing through cathode moves always in direction of connecting lead. When cathode spot reaches cathode face, unit for determination of cathode spot position sets level of electric signal which enters control unit. Control unit provides switching-on of controlled switch placed near cathode face opposite to cathode spot and simultaneous switching-off of another switch. Because cathode spot moves over cathode surface with uniform speed in space between detectors of final position of cathode spot, uniformity of movement does not allow control time of plasma flow effect on some parts of processed product according to given program. This results in processing which differs on product ends from its central zone.

Summary of the Invention

Described invention is based on the problem of creation of metal evaporator in which unit for determination of cathode spot position on cathode evaporation surface allows control of cathode spot movement by given program. This would result in uniform processing over whole surface of processed product.

The problem is accomplished by construction of unit for determination of cathode spot position on cathode evaporation surface is made detector of current position of cathode spot on cathode evaporation surface. Device also has cathode, which is extended along its longitudinal axis, made of evaporating material and having evaporation surface placed along its longitudinal axis, and connecting leads which are placed on the opposite sides of cathode and connected to controlled switches which are connected to each other and to direct current power supply. Direct current power supply is also connected to anode. Unit for determination of cathode spot position on cathode evaporation surface is connected to control unit.

Cathode can serve as detector of current position of cathode spot on cathode evaporation surface. Connecting leads of cathode can serve as connecting leads of detector.

It is reasonable that detector of current position of cathode spot is shaped as extended conductor which is made of high resistivity, which length is about half of cathode one, which has at its ends two connecting leads connected to input of control unit, and which is placed in close proximity to cathode evaporation surface.

It is reasonable that control unit has voltage converter, comparison unit, which output is connected to voltage converter and to separate turn-on members of controlled switches. First input of comparison unit is connected to power supply leads of cathode which also serves as detector of current position of cathode spot on cathode evaporation surface. Control unit also has programming unit which output is connected to second input of comparison unit.

It is reasonable that cathode, which also serves as detector of current position of cathode spot on cathode evaporation surface, is connected to first input of comparison unit through voltage converter, and that second input of comparison unit is connected to output of programming unit directly.
It is reasonable that power supply leads of cathode, which also serves as detector of current position of cathode spot on cathode evaporation surface, are connected to first input of comparison unit directly, and second input of comparison unit is connected to output of programming unit through voltage converter.

It is reasonable that control unit has comparison unit which first input is connected to power supply leads of extended conductor of detector of current position of cathode spot on cathode evaporation surface. It is reasonable that output of control unit is connected to separate turn-on members of controlled switches and that control unit has programming unit which output is connected to second input of comparison unit.

Such construction of evaporator applied for patent provides uniform processing of whole surface of processed product.

Brief Description of the Drawings

The following text explains invention by description of concrete examples of its realization and by attached drawings where:

Fig. 1 represents general diagram of electric arc metal evaporator which is applied for patent, (vacuum chamber is shown in longitudinal section);

Fig. 2 represents general diagram of another modification of evaporator construction, (vacuum chamber is shown in longitudinal section);

Fig. 3 represents general diagram of one more modification of evaporator construction, (vacuum chamber is shown in longitudinal section).

Detailed Description of the Invention.

Electric arc metal evaporator according to invention specification will be described using example of evaporator for electric arc hard-facing in vacuum.

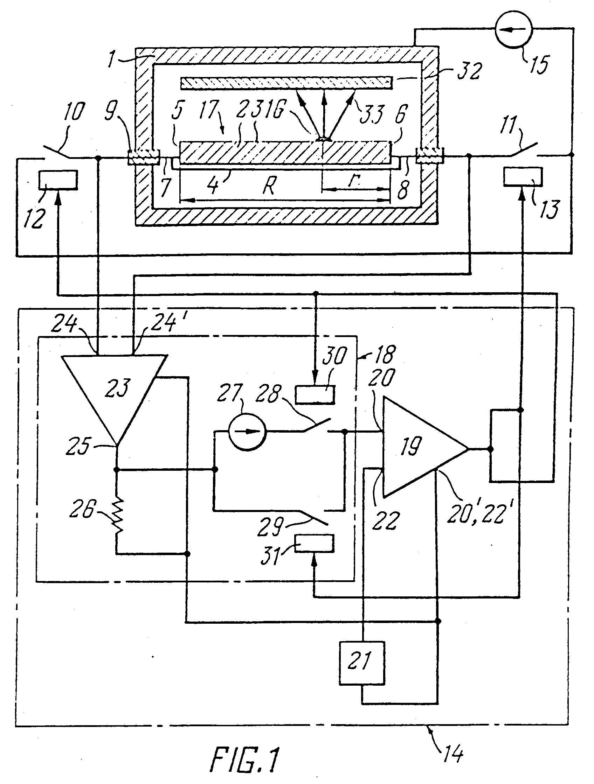

Electric arc metal evaporator according to invention specification has vacuum chamber 1 (Fig. 1) which serves as anode. Cathode 2, which is extended along its longitudinal axis, is made of evaporating material, e.g. titanium, and has evaporation surface extended along its longitudinal axis, is placed in vacuum chamber 1. Evaporation surface 3 of cathode 2 is limited by shield 4 insulated of cathode 2. Cathode 2 has on its faces 5 and 6 respective power supply leads 7 and 8 taken out through insulators 9 which are mounted into walls of chamber 1 outside of this chamber 1. Power supply leads 7 and 8 are connected to controlled switches 10 and 11 which are connected through separate turning-on members 12 and 13 to control unit 14 and to negative terminal of direct current power supply 14 which positive terminal is connected to vacuum chamber 1 which serves as anode.

Electric arc evaporator according to invention specification also has device for determination of cathode spot position 16 on evaporation surface 3 of cathode 2. Said device 16 is connected to control unit 14.

Described modification uses cathode 2 as detector 17 of cathode spot current position 16 on evaporation surface 3 of cathode 2. Cathode power supply leads 7 and 8 serves as power supply leads of detector 17.

Control unit 14 has voltage converter 18, comparison unit 19, which output is connected to voltage converter 18 and separate members 12 and 13 for turning-on control switches 10 and 11. First input 20, 20' of comparison unit 19 is connected to power supply leads 7 and 8 of cathode 2, which also serves as detector 17 of current position of cathode spot 16 on evaporation surface 3 of cathode 2. Control unit 14 also has programming device 21, which output is connected to second input 22, 22' of comparison unit 19.

Described modification of electric arc evaporator realization according to invention specification has electric connection of first input 20, 20' of comparison unit 19 through voltage converter 18 to power supply leads 7, 8 of cathode 2, which also serves as detector 17. Output of programming device 21 is connected to second input 22, 22' of comparison unit 19 directly.

In this case, voltage converter 18 has operational amplifier 23 which input 24, 24' is connected to power supply leads 7 and 8 of cathode 2, which also serves as detector 17. Operational amplifier output 25 is connected to loading resistor 26, switch 29, power supply 27, which is connected to switch 28. Switches 28 and 29 are connected to first input 20, 20' of comparison unit 19 and have respective turning-on members 30 and 31 which are connected to output of comparison unit 19.

Operational amplifier 23, loading resistor 26, programming unit 21 and comparison unit 19 are connected to common connection point.

Design of programming unit 21 is known for those skilled in the art. This unit executes program that determines generated control voltage.

Product 32 is placed in chamber 1 opposite to evaporation surface 3 of cathode 2. Metal plasma flow 33 which is generated by cathode spot 16 on evaporation surface 3 of cathode 2 is deposited on product 32.

Necessity for clearing of detector 17 from metal particles evaporated from cathode 2 can be avoided in the above described modification of electric arc evaporator realization according to invention specification.

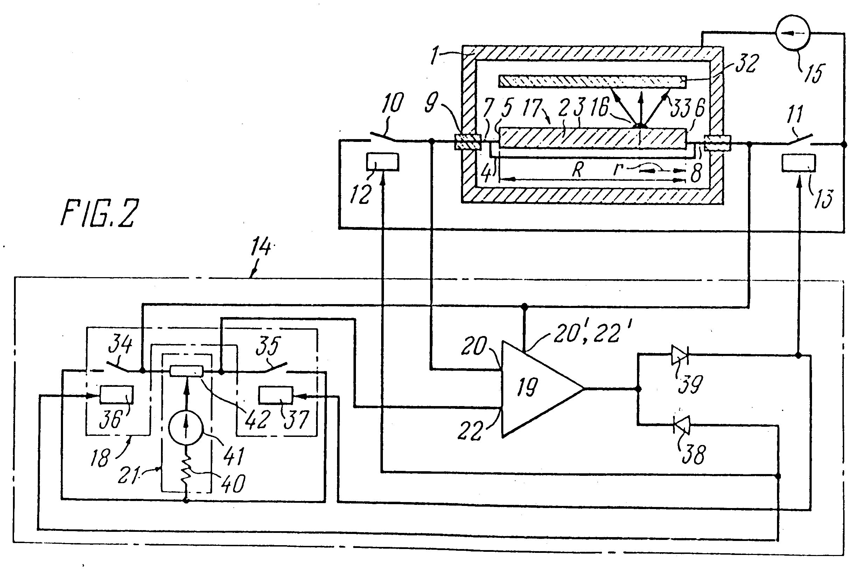

Modification of electric arc evaporator realization according to invention specification that is represented on Fig. 2 is analogous to modification represented on Fig. 1.

The difference is that electric connection of first input 20, 20' (Fig. 2) of comparison unit 19 to power supply leads 7 and 8 of cathode 2, which serves as detector 17, is immediate. Electric connection of output of programming unit 21 to second input 22, 22' (Fig. 2) of comparison unit 19 goes through voltage converter 18.

Voltage converter 18 has switches 34 and 35 connected to output of programming unit 21 and second input 22, 22' of comparison unit 19. Switches 34 and 35 have respective turning-on members 36, 37 which are connected through diodes 38 and 39 to output of comparison unit 19. Members 12 and 13 turning on controlled 10 and 11 are connected to output of comparison unit 19 through the same diodes 38 and 39.

Programming device 21 has resistor 40, control voltage supply 41 and potentiometer 42 connected in series. Terminals of potentiometer 42 are output of unit 21.

Switches 34 and 35 are connected to each other and to resistor 40 of programming unit 21.

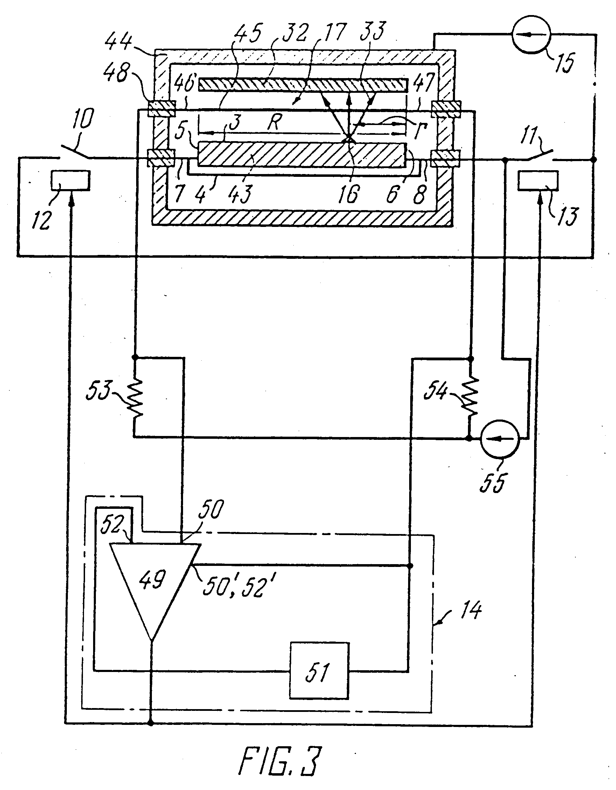

Modification of electric arc evaporator realization according to invention specification that is represented on Fig. 3 is analogous to modification represented on Fig. 1.

Difference is that detector 17 (Fig. 3) of cathode spot current position 16 evaporation surface 3 of cathode 43 is made as extended conductor 45 which is placed inside vacuum chamber 44, is made of material with high resistivity, e.g. Nichrome alloy, and has two power supply leads 46 and 47 on its ends. Length of conductor 45 equals approximately to length of cathode 43. Conductor 45 is placed in parallel to evaporation surface 3 of cathode 42 in close proximity to it. Power supply leads 46 and 47 are taken out through insulators 48, which are mounted in walls of chamber 44, outside of this chamber 44 and are connected to input of control unit 14.

Control unit 14 of described modification of electric arc evaporator realization according to invention specification has comparison unit 49 which first input 50, 50' is connected to power supply leads 46 and 47 of extended conductor 45 of detector 17. Output of comparison unit 49 is connected to separate members 12 and 13 for turning on controlled switches 10 and 11. In addition control unit 14 has programming unit 51 which output is connected to second input 52, 52' of comparison unit 49.

Power supply leads 46 and 47 of extended conductor 45 are connected to current stabilizers which are made as resistors 53 and 54. Resistors 53 and 54 are connected to each other and to positive terminal of direct current power supply 55 which negative terminal is connected to power supply lead 8 of cathode 2.

Programming unit 51 is the same as unit in evaporator modification according to Fig. 2 and has the same functional purpose.

Working principle of electric arc metal evaporator according to invention specification is the following.

Vacuum chamber 1 (Fig. 1) is pumped down by air pumping system (which is not shown on drawing) to pressure determined by technological purposes. Range of working pressure is limited on upper side by approximately 10 Pa and is practically unlimited on lower side because working medium where current is transferred consists of by-products of erosion of cathode 2 which are ionized by arc discharge. When given working pressure is achieved then anode (vacuum chamber 1) and cathode 2 are supplied from direct current power supply 15 and cathode spot 16 is initiated on evaporation surface 3 of cathode 2 by ignition device (which is not shown on the drawing because it is well-known and is not subject of this invention). Cathode spot 16 generates plasma flow 33 which extends mainly in the direction which is normal to evaporation surface 3 of cathode 2.
It is well-known that, for cathodes having extended form and power supply leads on the opposite sides of cathode, cathode spot of arc discharge always extends toward turned-on power supply lead. Arc discharge current passing through extended cathode 2 generates magnetic field which direction forces cathode spot 16 to move in the direction of turned-on power supply lead 7 or 8.

Reciprcations of cathode spot 16 on evaporation surface 3 of cathode 2 is accomplished by alternate turning on of power supply leads 7 and 8. Alternation of power supply leads is accomplished by controlled switches 10 and 11. When switch 11 is turned on, cathode spot 16 moves towards power supply lead 8. Voltage at terminals of cathode 2 is

$$U1 = i \cdot r,$$

where i is discharge current, and r is resistance cathode part between cathode spot 16 and face 6 of cathode 2. This voltage supplies input 24, 24' of operational amplifier 23 of voltage converter 18. Voltage U2 is generated on resistor 26 $U2 = k \cdot U1$, where U2 is voltage at output of converter 18 and k is scaling ratio.

This voltage supplies first input 20, 20' of comparison unit 19 through closed switch 29. Second input 22, 22' of comparison unit 19 receives voltage U3 from programming unit 21. Voltage U3 determines position of cathode spot 16 on cathode 2. If $k \cdot U1 = U3 > 0$ then switch 11 is closed. Cathode spot 16 moves along cathode towards power supply lead 8 until switch 10 turns on and switch 11 turns off.

When switch 10 is turned on, voltage at terminals of cathode 2 rises to a value $-(U - U1) = -i(R-r)$,

where R is resistance of cathode 2, and switch 29 is turned off and switch 28 is turned on at this time. Voltage converter 18 generates voltage $U2 = k \cdot (U1-U) + U4$, where $U$ is maximum voltage measured at detector 17 which is also cathode 2, U4 is voltage of power supply 27 which is adjusted to be equal to U.

So, $U2 = k \cdot U1$, i.e. input 20, 20' of comparison member 19 receives the same voltage at the moment of switching switches 28 and 29.

Modification of electric arc metal evaporator according to Fig. 2 operates analogous to evaporator according to Fig. 1.

The difference is that signal from cathode 2 which is also detector of current position of cathode spot 16 enters input 20, 20' of comparison unit 19 directly, and signal from programming unit 21 enters input 22,22' of comparison unit 19 through voltage converter 18.

If error signal enters inputs 20, 20' and 22, 22' of comparison unit 19 as the result of chaotic movement of cathode spot 16 over evaporation surface of cathode 2, then signal through diode 38 or 39 enters switching members 12 and 13 depending on polarity of input signal. When cathode spot 16 moves then switch corresponding to direction of displacement of cathode spot 16 is opened. This results in increasing value of signal picked from power supply leads 7, 8 of cathode 2 from U to -(U-U1). It is necessary for normal operation of evaporator that voltage determined by programming unit 21 changes from U3 to -(U-U3) when switches 10 and 11 are switched. Voltage converter 18 serves for this purpose.

Voltage converter 18 operates as follows.

Voltage from power supply 41 of programming unit 21 through resistor 40 and controlled switches 34 and 35 having switching circuits 36 and 37 supplies potentiometer 42. When switch 34 is closed then input 22, 22' of comparison unit 19 is supplied by voltage U3. When switch 35 is closed then input 22, 22' is supplied by voltage (U-U3), i.e. when signal generated by detector 17 of current position of cathode spot 16 increases, voltage at output of voltage converter 18 also increases.

Change of position of cathode spot 16 on cathode 2 is carried out by displacement of slider of potentiometer 42.

Modification of electric arc metal evaporator according to Fig. 3 operates analogous to evaporator according to Fig. 1.

The difference is that current stabilizers constructed in resistors 53 (Fig. 3), 54 form bridge which diagonally opposite pair of junctions is connected input 50, 50' of comparison unit 49. Resistance of each resistors 53 and 54 is such that it is by the order of magnitude higher than resistance R of conductor 45 of detector 17. When this condition is satisfied then voltage U5 at diagonally opposite pair of junctions of bridge equals to $U5 = i/2 (r - R/2)$.

Previous expression entails that voltage at diagonally opposite pair of junctions of bridge determines position of cathode spot 16 on evaporation surface 3 of cathode 2 unambiguously and first input 50,50' of comparison unit 49 receives signal directly generated at conductor 45 of detector 17. At the same time second input 52, 52' of comparison unit 49 receives signal from programming unit 51 and comparison unit 49 generates at its output an amplified signal which level is proportional to voltage difference at outputs 50, 50' and 52, 52'. When potentials at inputs 50, 50' and 52,52' of comparison unit 49 are equal then signal at its output is zero and both switches 10 and 11 closes. When both switches 10 and 11 are closed two directions of motion of cathode spot 16 are equivalent (cathode spot 16 moves chaotically). When position of cathode spot 16 changes potential at conductor 45 changes too and non-equal signals enter inputs 50, 50' and 52,52' of comparison unit 49. This results in increased potential at the output that opens switch corresponding to direction of increasing unbalance signal. Then cathode spot 16 begins movement in direction corresponding to decreasing unbalance signal.

So, comparison unit 49 and controlled switches 10 and 11, which are affected by it, constantly keep position of cathode spot on cathode 2 so that voltage difference is zero. When signal at output of programming unit 51 changes then voltage difference appears at inputs 50, 50' and 52,52' of comparison unit 49 and control unit 14 operates so that cathode spot 16 moves to new position on cathode 2 to restore voltage balance.

Cathode spot is moved in given direction according to given program by changing voltage at output of programming unit 51.

According to invention specification, electric arc metal evaporator, which is used in particular for electric arc hard-facing in vacuum, provides possibility of different profiles of coatings having given thickness.

Industrial Applicability.

Electric arc metal evaporator can be used for deposition hardening and decorative coatings on extended surfaces of such products as long shafts, tubes, tools, gears, hobbing cutters and also for all kinds of vacuum-plasma product processing including thermometrical and thermal processing and surface clearing of products.

**Claims**

1. An electric arc metal evaporator has a cathode (2) extending along its longitudinal axis, made of an evaporating material and having an evaporation surface along its longitudinal axis, and power supply leads (7, 8) positioned at different end faces (5, 6) of the cathode (2) and connected to controlled switches (10 and 11) which are connected through separate turn-on members (12,13) to a control unit (14) and to direct current power supply (15) which is also connected to the anode, and a means for determining position of a cathode spot (16) on the evaporation surface (3) of the cathode (2) which is connected to the control unit (14), characterized by the fact that the means for determining position of the cathode spot (16) on the evaporation surface (3) of the cathode (2) comprises a detector (17) of current position of the cathode spot (16) on the evaporation surface (3) of the cathode (2).

2. An electric arc evaporator as claimed in claim 1, characterized by the fact that the cathode (2) serves as the detector (17) of current position of the cathode spot (16) on the evaporation surface (3) of the cathode (2), the power supply leads (7, 8) of the cathode (2) are power supply leads of the detector (17).

3. An electric arc evaporator as claimed in claim 1, characterized by the fact that the detector (17) of current position of the cathode spot (16) on the evaporation surface (3) of the cathode (43) comprises an elongated conductor (45) which is made of a high resistivity material and which has a length approximately equal to the length of the cathode (43), the conductor (45) having at its ends two power supply leads (46, 47) which are connected to the input of the control unit (14) and being positioned in a close proximity to the evaporation surface (3) of the cathode (43).

4. An electric arc evaporator as claimed in claim 1, characterized by the fact that the control unit (14) comprises a voltage converter (18), a comparison unit (19) having an output connected to the voltage converter (18) and individual members (12, 13) for turning on controlled switches (10, 11), a first input (20,20') connected to power supply leads (7, 8) of the cathode (2), which also serves as the detector (17) of current position of the cathode spot (16) on the evaporation surface (3) of the cathode (2), and a programming unit having an output connected to the second input (22,22') of the comparison unit (19).

5. An electric arc evaporator as claimed in claim 4, characterized by the fact that the electric coupling of the first input (20,20') of the comparison unit (19) the power supply leads (7,8) of the cathode (2) which serves as the detector (17) of the current position of the cathode spot (16) on the evaporation surface (3) of the cathode (2) is effected through the voltage converter (18), and the second input (22,22') of the comparison unit (19) is directly electrically coupled to the output of the programming unit (21).

6. An electric arc evaporator as claimed in claim 4, characterized by the fact that the first input (20,20') of the comparison unit (19) is directly electrically coupled to the power supply leads (7,8) of the cathode (2) which serves as detector (17) of the current position of the cathode spot (16) on the evaporation surface (3) of the cathode (2), and the second input (22,22') of the comparison unit (19) is electrically coupled to the output of the programming unit (21) through the voltage converter (18).

7. An electric arc evaporator as claimed in claim 3, characterized by the fact that control unit (14) comprises a comparison unit (49) having a first input (50,50') connected to power supply leads (46,47) of the elongated conductor (45) of the detector (17) of the current position of the cathode spot (16) on the evaporation surface (3) of the cathode (2), the output of the comparison unit (49) being connected to individual members (12, 13) for turning on controlled switches (10, 11), and by the fact that it also comprises a programming unit (51) having an output connected to a second input (52,52') of the comparison unit (49).

FIG.1

FIG.2

EP 0 586 702 A1

FIG.3

| International application No. |
| --- |
| PCT/RU 92/00095 |

**A. CLASSIFICATION OF SUBJECT MATTER**

Int.Cl.$^5$   C23C 14/32

According to International Patent Classification (IPC) or to both national classification and IPC

**B. FIELDS SEARCHED**

Minimum documentation searched (classification system followed by classification symbols)

Int.Cl.$^5$   C23C14/00,14/24,14/32

Documentation searched other than minimum documentation to the extent that such documents are included in the fields searched

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | SU,A1,901358 (Spetsialnoe konstruktorskoe bjuro vakuumnykh pokryty pri gosplane Latviiskoi SSR), 30 January 1982 (30.01.1982) | 1-7 |
| A | DE,A1, 3731127 (VAC-TEC SYSTEMS, INC.) 22 September 1988 (22.09.88), abstract | 1-7 |
| A | EP,A1,0462303 (KABUSHIKI KAISHA KOBE SEIKO SHO), 27 December 1991 (27.12.91) abstract | 1-7 |

☐ Further documents are listed in the continuation of Box C.          ☐ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | |
| "O" document referring to an oral disclosure, use, exhibition or other means | "Y" document of particular relevance; the claimed invention cannot be considered to involve an inventive step when the document is combined with one or more other such documents, such combination being obvious to a person skilled in the art |
| "P" document published prior to the international filing date but later than the priority date claimed | "&" document member of the same patent family |

| Date of the actual completion of the international search | Date of mailing of the international search report |
| --- | --- |
| 16 July 1992 (16.07.92) | 15 August 1992 (15.08.1992) |

| Name and mailing address of the ISA/ | Authorized officer |
| --- | --- |
| ISA/RU | |
| Facsimile No. | Telephone No. |

Form PCT/ISA/210 (second sheet) (July 1992)